# EUROPEAN PATENT APPLICATION

(11) **EP 0 858 104 A2**
(43) Date of publication of application: **12.08.1998**
(21) Application number: 97306422.3
(22) Date of filing: 22.08.1997
(51) Int. Cl.: H01L 21/768

(54) **Method for forming multilevel interconnects in semiconductor device**

(30) Priority: 30.01.1997 KR 9702895
(71) Applicant: Samsung Electronics Co., Ltd., Suwon City, Kyungki-do (KR)
(72) Inventor: Chang, Seung-hyun, Bundang-gu, Seongnam-city, Kyungki-do (KR); Kim, Such-tae, Kangnam-gu, Seoul (KR); Park, Young-hun, Jangan-gu, Suwon-city, Kyungki-do (KR)
(74) Representative: Kyle, Diana

(57) **Abstract**

A method for forming a multilevel interconnects in a semiconductor device. In the multilevel interconnects forming method, a conductive layer pattern (130) is formed on a semiconductor substrate including a first insulating layer (120), to a thickness of Y1. A second insulating layer (140) is formed on the overall surface of the resultant including the conductive layer pattern (130). A lower conductive layer pattern is formed to a thickness of 2×Y1/3 on the second insulating layer to be separated from the conductive layer pattern by at least 3×Y1. On the overall surface of the resultant including the lower conductive layer pattern (150a,150b) is formed a third insulating layer (160). A planarization layer (170) is formed of spin-on-glass (SOG) on the third insulating layer (160) to expose the third insulating layer on the conductive layer pattern (130) and the lower conductive layer pattern (150a,150b). By forming this planarization layer, conductive layer pattern-induced fine cracks can be prevented from being produced on the SOG of a step portion.

## Description

The present invention relates to a manufacturing method for a semiconductor device, and more particularly, to a method for forming a multilevel interconnects in a semiconductor device using spin-on-glass (SOG) for a planarization layer.

As the integration level of semiconductor devices and their internal circuits are complicated, interconnects for a semiconductor device, which significantly influences the speed, product yield, and reliability of the semiconductor device, has employed a multilayered structure. A method for this multilevel interconnects is necessarily accompanied by planarization process to increase resolution and depth-of-focus in photolithography. Especially, planarization process using SOG has recently been applied widely to a semiconductor device manufacturing process due to its advantages of low cost, process simplification, no need for a poisonous gas, and a small defect density in the case of an SOG layer, when compared with other planarization processes.

Generally in the planarization process using SOG, liquid SOG is coated on a semiconductor substrate and baked at a temperature in a range of 150-400°C to remove solvents and moisture. During this process, the SOG is condensed and tensile stresses are created on an SOG layer, thereby producing fine cracks on the SOG layer. In particular, this phenomenon becomes serious on an about 3,000 Å or thicker SOG layer. The SOG layer is formed to be thicker mainly on a semiconductor device (chip) area adjacent to the edge of a semiconductor wafer. As thin films are continuously deposited, very large steps, that is, of 2.0 µm or above, are formed between the edge of the semiconductor wafer and its adjacent area for forming a semiconductor device therein since the edge of the semiconductor wafer is not exposed in photolithography. Therefore, an SOG layer formed in this area is 2.0 µm or thicker, thus being more susceptible to cracks.

To reduce such fine cracks, an SOG containing an organic group such as a methyl (CH₃⁻) group or a phenyl (C₆H₅⁻) group is usually used. The organic group-containing SOG is termed as an organic SOG, whereas an organic group-free SOG is termed as an inorganic SOG. The organic SOG is more volatile and harder to keep than the inorganic SOG. By overcoming these problems recently, a planarization technology using the organic SOG is more widely used in a method for forming a multilevel interconnects in a semiconductor device than that using the inorganic SOG.

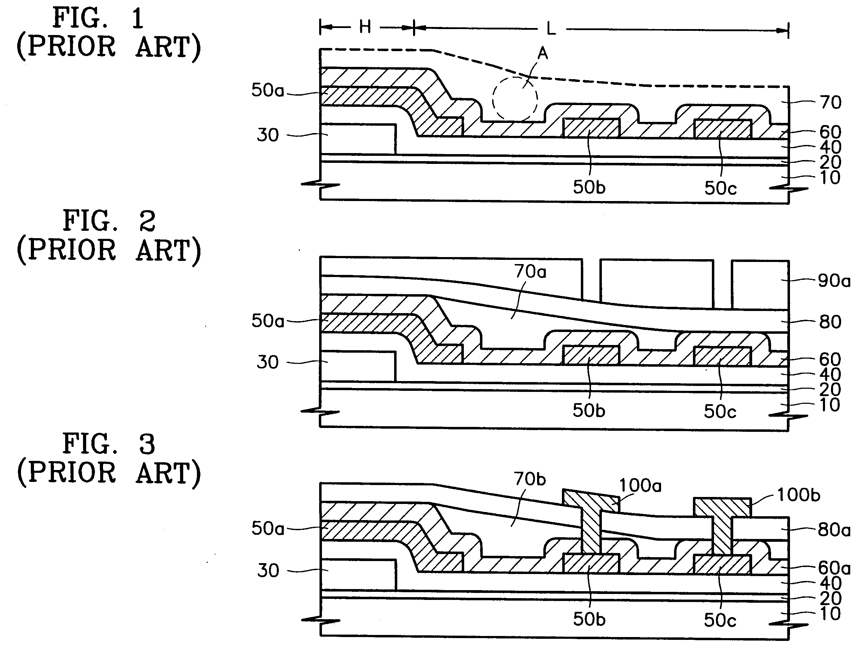

FIGs. 1, 2, and 3 are sectional views showing a conventional method for forming a multilevel interconnects in a semiconductor device.

FIG. 1 illustrates the step of forming a first insulating layer 20, a conductive layer pattern 30, a second insulating layer 40, lower conductive layer patterns 50a, 50b, and 50c, a third insulating layer 60, and an SOG layer 70.

First, the conductive layer pattern 30 is formed on a semiconductor substrate 10 having the first insulating layer 20 formed thereon. Then, the second insulating layer 40 is formed to a uniform thickness on the overall surface of the resultant including the conductive layer pattern 30. Here, steps are formed on the surface of the second insulating layer pattern 40 due to the thickness of the conductive layer pattern 30. Therefore, the resultant having the second insulating layer 40 formed thereon is divided into a first area H where the height between the surface of the semiconductor substrate 10 and the surface of the second insulating layer 40 is relatively high, and a second area L where the height is relatively low. As described above, steps are produced on the second insulating layer 40 mainly at the boundary between the edge of a semiconductor wafer and its adjacent area for forming a semiconductor device therein.

Subsequently, the lower conductive layer patterns 50a, 50b, and 50c are formed on the second insulating layer 40. Here, the first lower conductive layer pattern 50a is formed in the first area H, whereas the second and third lower conductive layer patterns 50b and 50c are formed in the second area L. The second lower conductive layer pattern 50b is positioned between the first and third lower conductive layer patterns 50a and 50c.

On the overall surface of the resultant including the lower conductive layer patterns 50a, 50b, and 50c is formed the third insulating layer 60 having uniform thickness. Then, the SOG layer 70 is formed by coating an inorganic or organic SOG on the third insulating layer 60 in a spin-on method. Here, SOG flows into the second area L due to its high fluidity, making the SOG layer thicker in the second area L than in the first area H. Therefore, the SOG layer 70 is relatively planar, and thickest in the second area L adjacent to the first area H. The second area L adjacent to the first area H is labeled by "A", and this is referred to as "area A" hereinafter.

Then, to remove solvents and moisture from the SOG layer 70, the SOG layer 70 is baked between 150 and 400°C. Here, the SOG layer 70 in area A is susceptible to fine cracks. Though fine cracks can be reduced by forming the SOG layer 70 of an organic SOG instead of an inorganic SOG, it is impossible to efficiently reduce the stress-induced fine cracks unless the SOG layer 70 is thinner.

FIG. 2 illustrates the step of forming a planarization layer 70a, a fourth insulating layer 80, and a photoresist layer pattern 90a.

The planarization layer 70a is formed by uniformly etching back the overall surface of the SOG layer 70 to a predetermined depth until the third insulating layer 60 on the third lower conductive layer pattern 50c is exposed. The reason for etch-back is to further planarize the surface of the SOG layer 70 and reduce the aspect ratio of a later-formed via hole.

Here, since the SOG layer 70 is thinner on the first lower conductive layer pattern 50a than on the third lower conductive layer pattern 50c, the third insulating layer 60 on the first lower conductive layer pattern 50a is obviously exposed. However, since the SOG layer 70 is thicker on the second lower conductive layer pattern 50b than on the third conductive layer pattern 50c, the third insulating layer 60 on the second lower conductive layer pattern 50b is not exposed. The planarization layer 70a is still thickest in area A, and thus susceptible to fine cracks in a subsequent heat treatment. Subsequently, the fourth insulating layer 80 is formed on the overall surface of the resultant having the planarization layer 70a formed thereon, and the photoresist layer pattern 90a is formed on the fourth insulating layer 80 to expose the fourth insulating layer 80 on the second and third lower conductive layer patterns 50b and 50c.

FIG. 3 illustrates the step of forming a fourth insulating layer pattern 80a, a planarization layer pattern 70b, a third insulating layer pattern 60a, and upper conductive layer patterns 100a and 100b.

The fourth insulating layer pattern 80a having via holes for exposing the second and third lower conductive layer patterns 50b and 50c, respectively, the planarization layer pattern 70b, and the third insulating layer pattern 60a are formed by sequentially etching the fourth insulating layer 80, the planarization layer 70a, and the third insulating layer 60, using the photosensitive layer pattern 90a as an etching mask.

Here, to simultaneously expose the second and third lower conductive layer patterns 50b and 50c, the upper portion of the second lower conductive layer pattern 50b should be further etched. Therefore, when the etching is performed for the purpose of exposing the third lower conductive layer pattern 50c, the second lower conductive layer pattern 50b may not be exposed. On the other hand, when the etching is performed for the purpose of exposing the second lower conductive layer pattern 50b, the upper portion of the third conductive layer pattern 50c may be over-etched. In this case, the via hole for exposing the third lower conductive layer pattern 50c becomes wider, resulting in connection between the via hole and its adjacent via hole (not shown), or exposing another conductive layer which should not be exposed.

Furthermore, if the SOG layer 70 is formed of an organic SOG as described referring to FIG. 1 to reduce fine cracks on the planarization layer 70a in area A, high molecular substances are produced during forming the via hole for exposing the second lower conductive layer pattern 50b, and these high molecular substances are locally accumulated on the second lower conductive layer pattern 50b, thereby increasing a contact resistance. The cause of formation of the high molecular substances is that Si and O components of the organic SOG are vaporized away in the state of SiF₄ and CO₂ by a carbon fluoride gas CF₄ or C₂F₆ used as a general etching gas, whereas organic components of the organic SOG are not removed by the carbon fluoride gas.

Then, the first and second upper conductive layer patterns 100a and 100b are formed on the fourth insulating layer pattern 80a to make contact with the second and third lower conductive layer patterns 50b and 50c through the via holes, respectively.

As described above, according to the conventional method for forming a multilevel interconnects in a semiconductor device, the planarization layer 70a in area A is susceptible to fine cracks, and the second lower conductive layer pattern 50b does not make contact with the first upper conductive layer pattern 100a or the via hole exposing the third lower conductive layer pattern 50c is larger than intended.

### Summary of the Invention

The object of the present invention is to provide a method for forming a multilevel interconnects in a semiconductor device to prevent formation of a thick planarization layer on steps.

To achieve the above object, in a method for forming a multilevel interconnects in a semiconductor device according to a first embodiment of the present invention, a conductive layer pattern is formed on a semiconductor substrate including a first insulating layer, to a thickness of Y1. A second insulating layer is formed on the overall surface of the resultant including the conductive layer pattern, and a lower conductive layer pattern is formed on the second insulating layer to be thinner than the conductive layer pattern, and to be separated from the conductive layer pattern by at least 3×Y1. On the overall surface of the resultant including the lower conductive layer pattern is formed a third insulating layer. A planarization layer of spin-on-glass (SOG) is formed on the third insulating layer to expose the third insulating layer on the conductive layer pattern and the lower conductive layer pattern, and a fourth insulating layer is formed on the planarization layer. After forming a via hole to expose the lower conductive layer pattern by etching the fourth and third insulating layers, an upper conductive layer pattern is formed to make contact with the lower conductive layer pattern through the via hole.

According to a method for forming a multilevel interconnects in a semiconductor device according to a second embodiment of the present invention, the lower conductive layer pattern on the second insulating layer may be separately formed into a first lower conductive layer pattern extends from the end portion of the conductive layer pattern by at least 3×Y3, covering the conductive layer pattern, and a second lower conductive layer pattern is separated from the first lower conductive layer pattern by a predetermined distance.

According to a method for forming a multilevel interconnects in a semiconductor device according to a third embodiment of the present invention, the width of the conductive layer pattern is increased to Z, and the lower conductive layer pattern on the second insulating layer is separately formed into a first lower conductive layer pattern located over the conductive layer pattern and separated from the end portion of the conductive layer pattern by at least 3×Y5, and a second lower conductive layer pattern separated from the end portion of the conductive layer pattern by at least 3×Y5.

The lower conductive layer pattern, and the first and second lower conductive layer patterns are substantially thinner than 2×Y3.

According to a method for forming a multilevel interconnects in a semiconductor device according to a fourth embodiment of the present invention, a dummy pattern is formed on a semiconductor substrate including a first insulating layer. A second insulating layer is formed on the overall surface of the resultant including the dummy pattern, and a conductive layer pattern is formed on the second insulating layer free of the dummy pattern to a thickness of Y larger than that of the dummy pattern. On the overall surface of the resultant including the conductive layer pattern is formed a third insulating layer. A first lower conductive layer pattern is formed on the third insulating layer on the conductive layer pattern to be thinner than the conductive layer pattern and, simultaneously, a second lower conductive layer pattern is formed on the third insulating layer to face the conductive layer pattern and to be as thick as the first lower conductive layer pattern, which the dummy pattern intervening between the first lower conductive layer pattern and the second lower conductive layer pattern. A fourth insulating layer is formed on the overall surface of the resultant including the first and second lower conductive layer patterns. A planarization layer is formed of spin-on-glass (SOG) on the fourth insulating layer to expose the fourth insulating layer on the first and second lower conductive layer patterns. A fifth insulating layer is formed on the planarization layer. After forming a via hole to expose the second lower conductive layer pattern by etching the fifth and fourth insulating layers, an upper conductive layer pattern is formed to make contact with the second lower conductive layer pattern through the via hole.

### Brief Description of the Drawings

The object and advantages of the present invention will become more apparent by describing in detail preferred embodiments thereof with reference to the attached drawings in which:
FIGs. 1, 2, and 3 are sectional views showing a conventional method for forming a multilevel interconnects in a semiconductor device;
FIGs. 4, 5, and 6 are sectional views showing a method for forming a multilevel interconnects in a semiconductor device according to an embodiment of the present invention;
FIGs. 7, 8, and 9 are sectional views showing a method for forming a multilevel interconnects in a semiconductor device according to another embodiment of the present invention;
FIGs. 10, 11, and 12 are sectional views showing a method for forming a multilevel interconnects in a semiconductor device according to still another embodiment of the present invention; and
FIGs. 13, 14, and 15 are sectional views showing a method for forming a multilevel interconnects in a semiconductor device according to a further embodiment of the present invention.

### Detailed Description of the Invention

### EMBODIMENT 1

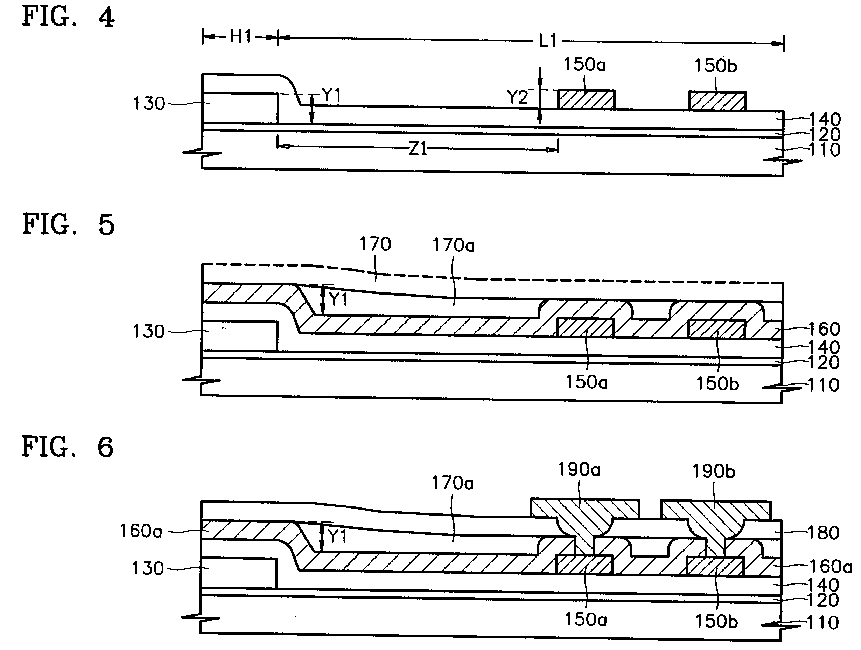

FIGs. 4, 5, and 6 are sectional views showing a method for forming a multilevel interconnects in a semiconductor device according to an embodiment of the present invention.

FIG. 4 illustrates the step of forming a first insulating layer 120, a conductive layer pattern 130, a second insulating layer 140, and lower conductive layer patterns 150a and 150b. First, the conductive layer pattern 130 is formed to a thickness of Y1, that is, 5,000-10,000 Å on a semiconductor substrate 110 including the first insulating layer 120 which is 1,000-5,000 Å thick. Then, the second insulating layer 140 is formed to a thickness of 1,000-5,000 Å on the overall surface of the resultant having the conductive layer pattern 130 formed thereon. Here, steps are produced on the surface of the second insulating layer 140 due to the thickness of the conductive layer pattern 130. Therefore, the resultant having the second insulating layer 140 formed thereon is divided into a first area H1 where the height between the surface of the semiconductor substrate 110 and the surface of the second insulating layer 140 is relatively high, and a second area L1 where the height is relatively low. Subsequently, a lower conductive layer is formed on the second insulating layer 140 to a thickness of Y2, that is, 2×Y1/3 or smaller.

The first and second lower conductive layer patterns 150a and 150b are formed by patterning the lower conductive layer until the second insulating layer 140 is exposed, so that the former is separated from the conductive layer pattern 130 by at least 3×Y1 (Z1) and the latter is separated from the first lower conductive layer pattern 150a by a predetermined distance. Here, the first lower conductive layer pattern 150a is positioned between the conductive layer pattern 130 and the second lower conductive layer pattern 150b.

FIG. 5 illustrates the step of forming a third insulating layer 160 and a planarization layer 170a. The third insulating layer 160 is formed to a uniform thickness on the overall surface of the resultant having the lower conductive layer pattern 150a and 150b, formed thereon. Then, an SOG layer 170 is formed by coating an inorganic or organic SOG on the third insulating layer 160 in a spin-on method, and baked in a range of 150-400°C.

Here, the SOG layer 170 has a relative planar surface, and is formed to be thickest at the boundary of the second area L1 adjacent to the first area H1. However, since there is no lower conductive layer pattern 50a of FIG. 1 on the conductive layer pattern 130 in contrast to the prior art, steps on the third insulating layer 160 are lower than those in the prior art. As a result, the SOG layer 170 formed at the boundary of the second area L1 adjacent to the first area H1 is thinner than in the prior art. Therefore, fine cracks are prevented from being produced on the SOG layer 170 in a subsequent heat treatment as well as during baking the SOG layer 170.

Then, the planarization layer 170a is formed by etching back the overall surface of the SOG layer 170 to a predetermined depth until the third insulating layer 160 on the second lower conductive layer pattern 150b is exposed. Here, the third insulating layer 160 on the conductive layer pattern 130 is obviously exposed because the SOG layer 170 is thinner on the conductive layer pattern 130 than on the second lower conductive layer pattern 150b. In addition, since steps on the third insulating layer 160 are smaller than in the prior art and the first lower conductive layer pattern 150a is separated from the conductive layer pattern 130 by at least 3×Y1, the SOG layer 170 on the first lower conductive layer pattern 150a is as thick as that on the second lower conductive layer pattern 150b, in contrast to the prior art. Therefore, when the third insulating layer 160 on the second lower conductive layer pattern 150b is exposed, there is no planarization layer 170a on the first lower conductive layer pattern 150a due to the exposure of the third insulating layer 160 on the first conductive layer pattern 150a.

FIG. 6 illustrates the step of forming a fourth insulating layer pattern 180, a third insulating layer pattern 160a, and upper conducive layer patterns 190a and 190b. First, a fourth insulating layer is formed on the planarization layer 170a to a thickness of 4,000-7,000 Å, Then, the fourth insulating layer pattern 180 and the third insulating layer pattern 160a are formed to have via holes for exposing the lower conductive layer patterns 150a and 150b, respectively, by sequentially etching the fourth insulating layer and the third insulating layer 160 on the lower conductive layer pattern 150a and 150b. Here, no conventional problems are generated during forming the via holes since there is no planarization layer 170a on the first lower conductive layer pattern 150a. Then, the upper conductive layer patterns 190a and 190b are formed on the fourth insulating layer pattern 180 to make contact with the lower conductive layer patterns 150a and 150b through the via holes, respectively.

### EMBODIMENT 2

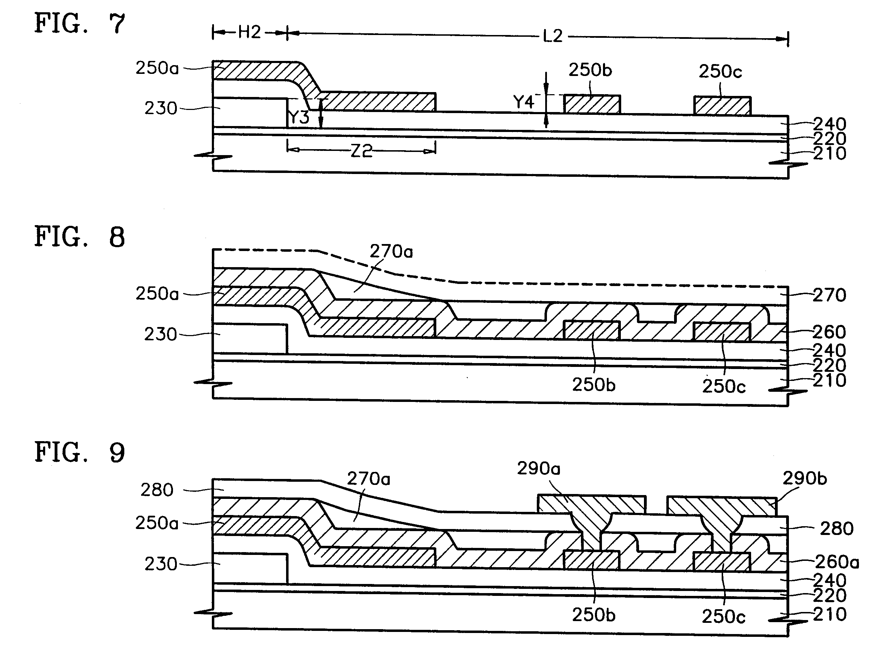

FIGs. 7, 8, and 9 are sectional views showing a method for forming a multilevel interconnects in a semiconductor device according to a second embodiment of the present invention.

The second embodiment of the present invention is different from the first embodiment in that the lower conductive patterns on the second insulating layer 240 include a first lower conductive layer pattern 250a which extends from the end portion of the conductive layer pattern 230 by 3×Y3 (Z2), covering the conductive layer pattern 230, and a second lower conductive layer pattern 250b separated from the first lower conductive layer pattern 250a by a predetermined distance.

FIG. 7 illustrates the step of forming a first insulating layer 220, a conductive layer pattern 230, a second insulating layer 240, and lower conductive layer patterns 250a, 250b, and 250c. First, the conductive layer pattern 230 is formed to a thickness of Y3, that is, 5,000-10,000 Å on a semiconductor substrate 210 including the first insulating layer 220 which is 1,000-5,000 Å thick. Then, the second insulating layer 240 is formed to a thickness of 1,000-5,000 Å on the overall surface of the resultant having the conductive layer pattern 230 formed thereon. Here, steps are produced on the surface of the second insulating layer 240 due to the thickness of the conductive layer pattern 230. Therefore, the resultant having the second insulating layer 240 formed thereon is divided into a first area H2 where the height between the surface of the semiconductor substrate 210 and the surface of the second insulating layer 240 is relatively high, and a second area L2 where the height is relatively low. Subsequently, a lower conductive layer is formed on the second insulating layer 240 to a thickness of Y4, that is, 2× Y3/3 or below.

By patterning the lower conductive layer until the second insulating layer 240 is exposed, the first conductive layer pattern 250a is formed to extend from the conductive layer pattern 230 by at least 3×Y3 (Z2) covering the conductive layer pattern 230, and the second and third lower conductive layer patterns 250b and 250c are formed to be away from the first lower conductive layer pattern 250a by predetermined distances, respectively. Here, the second lower conductive layer pattern 250b is positioned between the first and third lower conductive layer patterns 250a and 250c.

FIG. 8 illustrates the step of forming a third insulating layer 260 and a planarization layer 270a. The third insulating layer 260 is formed to a uniform thickness on the overall surface of the resultant having the lower conductive layer patterns 250a, 250b, and 250c. Then, an SOG layer 170 is formed by coating an inorganic or organic SOG on the third insulating layer 260 in a spin-on method, and baked in a range of 150-400° C.

Since, in contrast to the prior art, the first lower conductive layer pattern 250a extends from the conductive layer pattern 230 by at least 3×Y3, covering the conductive layer pattern 230, steps on the third insulating layer 260 in the second area L2 adjacent to the first area H2 are lower than those in the prior art. Therefore, the SOG layer 270 is thinner in the second area L2 adjacent to the first area H2 than in the prior art, thus preventing formation of fine cracks on the SOG layer 270 in a subsequent heat treatment as well as during baking the SOG layer 270.

The planarization layer 270a is formed by etching back the overall surface of the SOG layer 270 to a predetermined depth until the third insulating layer 260 on the third lower conductive layer pattern 250c is exposed. Here, since the SOG layer 270 is thinner on the conductive layer pattern 230 than on the third lower conductive layer pattern 250c, the third insulating layer 260 on the conductive layer pattern 230 is also exposed. The steps on the third insulating layer 23O are small, and the SOG layer 270 is as thick on the second lower conductive layer pattern 250b as on the third lower conductive layer pattern 250c in contrast to the prior art, because the second lower conductive layer pattern 250b is sufficiently separated from the conductive layer pattern 230 by the first lower conductive layer pattern 250a. Therefore, when the third insulating layer 260 on the third lower conductive layer pattern 250c is exposed, there is no planarization layer 270a on the second lower conductive layer pattern 250b due to the exposure of the third insulating layer 260 on the second conductive layer pattern 250b.

FIG. 9 illustrates the step of forming a fourth insulating layer pattern 280, a third insulating layer pattern 260a, and upper conductive layer patterns 290a and 290b. First, a fourth insulating layer is formed on the planarization layer 270a to a thickness of 3,000-7,000 Å. Then, the fourth insulating layer pattern 280 and the third insulating layer pattern 260a are to have via holes for exposing the second and third insulating layers 250b and 250c, respectively, by sequentially etching the fourth insulating layer and the third insulating layer 260 on the second and third lower conductive layer patterns 250b and 250c. Here, since there is no planarization layer 270a on the second lower conductive layer pattern 250b, no conventional problems are generated during forming the via holes. Then, the upper conductive layer patterns 290a and 290b are formed on the fourth insulating layer pattern 280 to make contact with the second and third conductive layer patterns 250b and 250c, respectively, through the via holes.

### EMBODIMENT 3

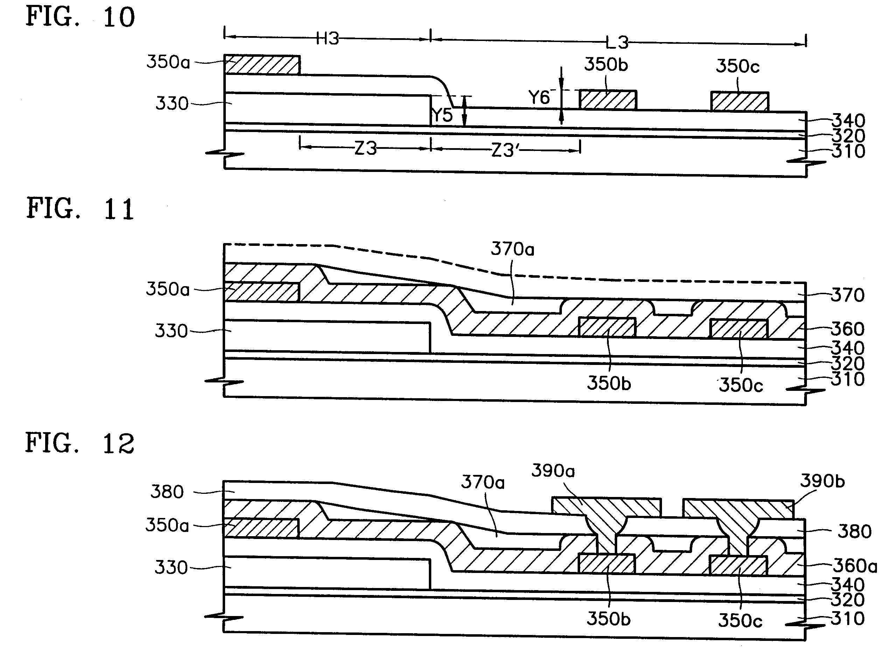

FIGs. 10, 11, and 12 are sectional views showing a method for forming a multilevel interconnects in a semiconductor device according to a third embodiment of the present invention.

The third embodiment of the present invention is different from the first embodiment in that the width of the conductive layer pattern 330 is increased by Z3, and the lower conductive layer patterns on the second insulating layer 340 includes a first lower conductive layer pattern 350a formed over the conductive layer pattern 330 and separated from the end portion of a conductive layer pattern 330 by at least 3×Y5 (Z3), and a second lower conductive layer pattern 350b separated from the end portion of the conductive layer pattern 330 by at least 3×Y5 (Z3').

FIG. 10 illustrates the step of forming a first insulating layer 320, a conductive layer pattern 330, a second insulating layer 340, and lower conductive layer patterns 350a, 350b, and 350c. First, the conductive layer pattern 330 is formed to a thickness of Y5, that is, 5,000-10,000Å on a semiconductor substrate 310 including the first insulating layer 320 which is 1,000-5,000Å thick. Then, the second insulating layer 340 is formed to a thickness of 1,000-5,000Å on the overall surface of the resultant including the conductive layer pattern 330. Here, steps are formed on the surface of the second insulating layer 340 due to the thickness of the conductive layer pattern 330. Therefore, the resultant having the second conductive layer pattern 340 formed thereon is divided into a first area H3 where the height between the surface of the semiconductor substrate 310 and the surface of the second insulating layer 340 is relatively high, and a second area L3 where the height is relatively low. Subsequently, a lower conductive layer is formed on the second insulating layer 340 to a thickness of Y6. Here, Y6 is smaller than 2×Y5/3.

Then, by patterning the lower conductive layer until the second insulating layer 340 is exposed. the first lower conductive layer pattern 350a is formed on the second insulating layer 340 on the conductive layer pattern 330 to be separated from the end portion of the conductive layer pattern 330 by at least 3×Y5 (Z3) and, simultaneously, the second and third lower conductive layer patterns 350b and 350c are formed on the second insulating layer 340 so that the former is separated from the conductive layer pattern 330 by at least 3×Y5 (Z3') and the latter is separated from the second lower conductive layer pattern 350b by a predetermined distance. Here, the second lower conductive layer pattern 350b is positioned between the first and third lower conductive layer patterns 350a and 350c.

FIG. 11 illustrates the step of forming a third insulating layer 360 and a planarization layer 370a. First, the third insulating layer 360 is formed to a predetermined thickness on the overall surface of the resultant including the lower conductive layer patterns 350a, 350b, and 350c. Then, an SOG layer 370 is formed by coating an inorganic or organic SOG on the third insulating layer 360 in a spin-on method, and baked in a range of 150-400° C.

Here, though the first lower conductive layer pattern 350a is formed over the conductive layer pattern 330, it avoids the first area H3 adjacent to the second area L3 since it is separated from the end portion of the conductive layer pattern 330 by at least 3×Y5, in contrast to the prior art. Therefore, as described in embodiment 1, the SOG layer 370 is formed to be thin in the second area L3 adjacent to the first area H1, when compared to the prior art, thereby preventing formation of fine cracks on the SOG layer 370 in a subsequent heat treatment as well as during baking the SOG layer 370.

Then, the planarization layer 370a is formed by etching the overall surface of the SOG layer 370 to a predetermined depth until the third insulating layer 360 on the third lower conductive layer pattern 350c is exposed. Here, when the third insulating layer 360 on the third lower conductive layer pattern 350c is exposed, the third insulating layer 360 on the second lower conductive layer pattern 350b is also exposed, since the second lower conductive layer pattern 350b is formed to be separated from the conductive layer pattern by at least 3×Y5, as described in embodiment 1. As a result, no planarization layer 370a exists on the second lower conductive layer pattern 350b.

FIG. 12 illustrates the step of forming a fourth insulating layer pattern 380, a third insulating layer pattern 360a, and upper conductive layer patterns 390a and 390b. First, a fourth insulating layer is formed on the planarization layer 370a to a thickness of 3,000-7,000 Å. Then, the fourth insulating layer pattern 380 and the third insulating layer pattern 360a are formed to have via holes for exposing the second and third lower conductive layer patterns 350b and 350c, respectively, by sequentially etching the fourth insulating layer and the third insulating layer 360 on the second and third lower conductive layer patterns 350b and 350c. Since there is no planarization layer 370a on the second lower conductive layer pattern 350b in contrast to the prior art, no conventional problems are generated during forming the via holes. Then, the upper conductive layer patterns 390a and 390b are formed on the fourth insulating layer pattern 380 to make contact with the second and third lower conductive layer patterns 350b and 350c through the via holes, respectively.

### EMBODIMENT 4

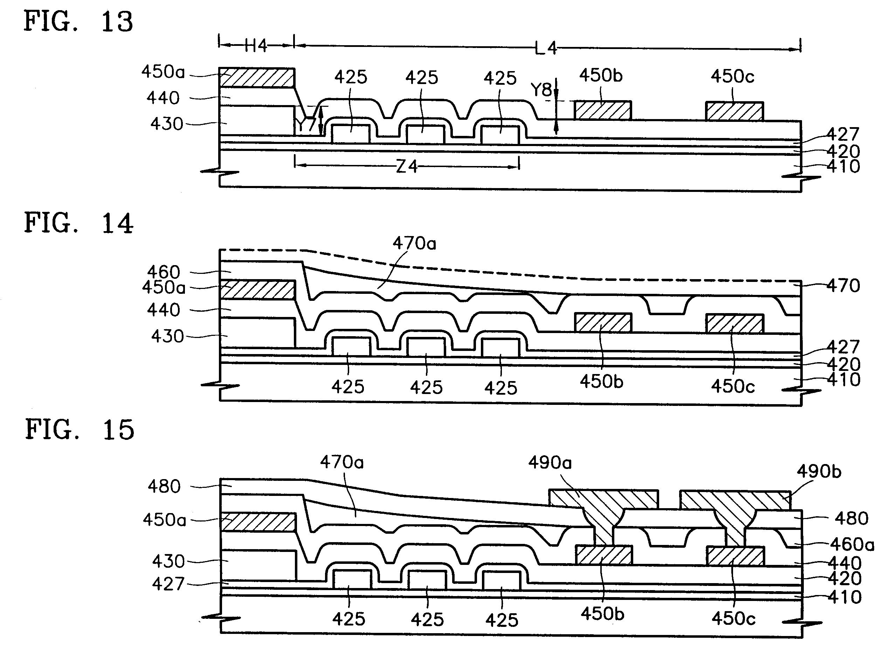

FIGs. 13, 14, and 15 are sectional views showing a method for forming a multilevel interconnects in a semiconductor device according to a fourth embodiment of the present invention.

The fourth embodiment of the present invention is different from the third embodiment in that dummy patterns 425 are formed on the first insulating layer 420, and a first lower conductive layer pattern 450a is formed on the third insulating layer 440 over the conductive layer pattern 430 to be thinner than the conductive layer pattern, simultaneously with formation of a second lower conductive layer pattern 450b on the third insulating layer 440 to be as thick as the first lower conductive layer pattern 450a, facing the conductive layer pattern 440 with the dummy patterns 425 intervening between them.

FIG. 13 illustrates the step of forming a first insulating layer 420, dummy patterns 425, a second insulating layer 427, a conductive layer pattern 430, a third insulating layer 440, and lower conductive layer patterns 450a, 450b, and 450c. First, the dummy patterns 425 are formed to a thickness of 1,000-5,000Å on a semiconductor substrate 410 including the first insulating layer 420 which is 1,000-5,000 Å thick. Here, the dummy patterns 425 may be integrated. Then, the second insulating layer 427 is formed to be 1,000-5,000 Å thick on the overall surface of the resultant including the dummy patterns 425. Then, the conductive layer pattern 430 is formed on a dummy pattern-free portion of the second insulating layer 427 to a thickness of Y7, that is, 5,000-10,000 Å, larger than the thickness of the dummy patterns 425. Here, the conductive layer pattern 430 is formed to be separated from the end portion of the farthest dummy pattern 425 by 3×Y7 (Z4).

Then, the third insulating layer 440 is formed on the overall surface of the resultant having the conductive layer pattern 430 formed thereon. Here, steps are formed on the surface of the third insulating layer 440 due to the thickness of the conductive layer pattern 430. Therefore, the resultant including the third insulating layer 440 is divided into a first area H4 where the height between the surface of the semiconductor substrate 410 and the surface of the third insulating layer 440 is relatively high, and a second area L4 where the height is relatively low. Then, a lower conductive layer is formed on the third insulating layer 440 to a thickness of Y8. Y8 is smaller than 2×Y7/3.

By patterning the lower conductive layer until the third insulating layer 440 is exposed, the first lower conductive layer pattern 450a is formed on the third insulating layer 440 on the conductive layer pattern 430 and, simultaneously, the second and third conductive layer patterns 450b and 450c are formed on the third insulating layer 440 to face the conductive layer pattern 430 and be spaced apart from the dummy pattern 425 which is farthest from the conductive layer pattern 430 by predetermined distances. Here, the second lower conductive layer pattern 450b is positioned between the first and third conductive layer patterns 450a and 450c.

FIG. 14 illustrates the step of forming a fourth insulating layer 460 and a planarization layer 470a. First, the fourth insulating layer 460 is formed to a uniform thickness on the resultant including the lower conductive layer patterns 450a, 450b, and 450c. Then, an SOG layer 470 is formed by coating an inorganic or organic SOG on the fourth insulating layer 460 in a spin-on method, and baked in a range of 150-400° C.

Here, steps on the fourth insulating layer 460 at the boundary between the first and second areas H4 and L4 are smaller than those of the prior art due to the dummy patterns 425. Therefore, the SOG layer 470 formed in the second area L4 adjacent to the first area H4 is thinner than in the prior art, thus preventing formation of fine cracks on the SOG layer 470 in a subsequent heat treatment as well as during baking the SOG layer 470.

The planarization layer 470a is formed by etching back the overall surface of the SOG layer 470 to a predetermined depth until the fourth insulating layer 460 on the third lower conductive layer pattern 450c is exposed. Here, since the SOG layer 470 is thinner on the first conductive layer pattern 450a than on the third lower conductive layer pattern 450c, the fourth insulating layer 460 on the first lower conductive layer pattern 450a is exposed. Since the second lower conductive layer pattern 450b is sufficiently separated from the conductive layer pattern 430 due to the dummy patterns 425, the SOG layer 470 is almost as thick on the second lower conducive layer pattern 450b as on the third lower conductive layer pattern 450c. Therefore, when the fourth insulating layer 460 on the third lower conductive layer pattern 450c is exposed, there is no planarization layer 470 on the second lower conductive layer pattern 450b due to exposure of the fourth insulating layer 460 on the second lower conductive layer pattern 450b.

FIG. 15 illustrates the step of forming a fifth insulating layer pattern 480, a fourth insulating layer pattern 460a, and upper conductive layer patterns 490a and 490b. First, a fifth insulating layer is formed on the planarization layer 470a to a thickness of 3,000-7,000 Å. Then, the fifth insulating layer pattern 480 and the fourth insulating layer pattern 460a are formed to have via holes for exposing the second and third lower conductive layer patterns 450b and 450c, respectively, by sequentially etching the fifth insulating layer and the fourth insulating layer 460 on the second and third lower conductive layer patterns 450b and 450c. Here, since there is no planarization layer 470a on the second lower conductive layer pattern 450b, no conventional problems are generated during forming the via holes. Then, the upper conductive layer patterns 490a and 490b are formed on the fifth insulating layer pattern 480 to make contact with the second and third lower conductive layer patterns 450b and 450c through the via holes, respectively.

As described above, in the method for forming a multilevel interconnects in a semiconductor device according to the present invention, since the SOG layer is not thick on a step portion, fine cracks are prevented from being produced on the SOG layer of the step portion in a subsequent heat treatment as well as during baking via holes. In addition, the absence of the planarization layer on the lower conductive layer patterns which is to contact the upper conductive layer patterns prevent abnormal contact between the lower conductive patterns and the upper conductive layer patterns and unintended increase in the size of the via holes.

The present invention is not limited to the above embodiments, and it is clearly understood that many variations are possible within the scope and spirit of the present invention by anyone skilled in the art.

## Claims

1. A method for forming a multilevel interconnects in a semiconductor device, comprising the steps of:
(a) forming a conductive layer pattern (130) on a semiconductor substrate including a first insulating layer (120), to a thickness of Y1;
(b) forming a second insulating layer (140) on the overall surface of the resultant including the conductive layer pattern (130);
^{©} forming a lower conductive layer pattern (150a,150b) on the second insulating layer (140) to be thinner than the conductive layer pattern (130), and to be separated from the conductive layer pattern by at least 3×Y1;
(d) forming a third insulating layer (160) on the overall surface of the resultant including the lower conductive layer pattern;
(e) forming a planarization layer (170) of spin-on-glass (SOG) on the third insulating layer (160) to expose the third insulating layer on the conductive layer pattern and the lower conductive layer pattern;
(f) forming a fourth insulating layer (180) on the planarization layer;
(g) forming a via hole to expose the lower conductive layer pattern (150a,150b) by etching the fourth and third insulating layers; and
(h) forming an upper conductive layer pattern (190a,190b) to make contact with the lower conductive layer pattern (150a,150b) through the via hole.

2. The method of claim 1, wherein the lower conductive layer pattern (150a,150b) is substantially thinner than 2×Y1/3.

3. The method of claims 1 or 2, wherein the step (e) comprises the substeps of: forming an SOG layer on the third insulating layer (160); baking the SOG layer; and etching back the SOG layer to expose the third insulating layer (160) on the conductive layer pattern (130) and the lower conductive layer pattern (150a,150b).

4. A method for forming a multilevel interconnects in a semiconductor, comprising the steps of:
(i) forming a conductive layer pattern (230) on a semiconductor substrate including a first insulating layer (220), to a thickness of Y3;
(j) forming a second insulating layer (240) on the overall surface of the resultant including the conductive layer pattern (230);
(k) forming a first (250a) and a second (250b) lower conductive layer patterns on the second insulating layer (240) to be thinner than the conductive layer pattern so that the first lower conductive layer pattern (250a) extends from the end portion of the conductive layer pattern by at least 3×Y3, covering the conductive layer pattern, and the second lower conductive layer pattern (250b,250c) is separated from the first lower conductive layer pattern by a predetermined distance;
(l) forming a third insulating layer (260) on the overall surface of the resultant including the first and second lower conductive layer patterns;
(m) forming a planarization layer (270a) of spin-on-glass (SOG) on the third insulating layer (260) to expose the third insulating layer on the conductive layer pattern and the second lower conductive layer pattern;
(n) forming a fourth insulating layer (280) on the planarization layer (270a);
(o) forming a via hole to expose the second lower conductive layer pattern by etching the fourth and third insulating layers; and
(p) forming an upper conductive layer pattern (290a,290b) to make contact with the second lower conductive layer pattern (250b,250c) through the via hole.

5. The method of claim 4, wherein the first and second lower conductive layer patterns are substantially thinner than 2×Y3/3.

6. The method of claim 4 or 5, wherein the step (m) comprises the substeps of: forming an SOG layer on the third insulating layer (260); baking the SOG layer; and etching back the SOG layer to expose the third insulating layer (260) on the first and second lower conductive layer patterns (250a,250b,250c).

7. A method for forming a multilevel interconnects in a semiconductor, comprising the steps of:
(q) forming a conductive layer pattern (330) on a semiconductor substrate including a first insulating layer (320), to a thickness of Y5;
(r) forming a second insulating layer (340) on the overall surface of the resultant including the conductive layer pattern (330);
(s) forming first (350a) and second (350b,350c) lower conductive layer patterns on the second insulating layer to be thinner than the conductive layer pattern so that the first lower conductive layer pattern (350a) is located over the conductive layer pattern (330) and the first (350a) and second (350b,350c) lower conductive layer patterns are in opposite direction separated from the end portion of the conductive layer pattern by at least 3×Y5;
(t) forming a third insulating layer (360) on the overall surface of the resultant including the first and second lower conductive layer patterns;
(u) forming a planarization layer (370a) of spin-on-glass (SOG) on the third insulating layer (360) to expose the third insulating layer on the conductive layer pattern and the second lower conductive layer pattern;
(v) forming a fourth insulating layer (380) on the planarization layer;
(w) forming a via hole to expose the second lower conductive layer pattern by etching the fourth and third insulating layers; and
(x) forming an upper conductive layer pattern (390a,390b) to make contact with the second lower conductive layer pattern through the via hole.

8. The method of claim 7, wherein the first (350a) and second (350b,350c) lower conductive layer patterns are substantially thinner than 2×Y5/3.

9. The method of claim 7 or 8, wherein the step (u) comprises the substeps of: forming an SOG layer on the third insulating layer (360); baking the SOG layer; and etching back the SOG layer to expose the third insulating layer (360) on the first and second lower conductive layer patterns (350a,350b,350c).

10. A method for forming a multilevel interconnects in a semiconductor, comprising the steps of:
(a') forming a dummy pattern (425) on a semiconductor substrate including a first insulating layer (420);
(b') forming a second insulating layer (427) on the overall surface of the resultant including the dummy pattern;
(c') forming a conductive layer pattern (430) on the second insulating layer free of the dummy pattern to a thickness of Y7 substantially larger than that of the dummy pattern;
(d') forming a third insulating layer (440) on the overall surface of the resultant including the conductive layer pattern;
(e') forming a first lower conductive layer pattern (450a) on the third insulating layer on the conductive layer pattern to be thinner than the conductive layer pattern, and simultaneously forming a second lower conductive layer pattern (450b,450c) on the third insulating layer to face the conductive layer pattern and to be as thick as the first lower conductive layer pattern, with the dummy pattern intervening between the first lower conductive layer pattern (450a) and the second lower conductive layer pattern (450b);
(f') forming a fourth insulating layer (460) on the overall surface of the resultant including the first and second lower conductive layer patterns;
(g') forming a planarization layer (470a) of spin-on-glass (SOG) on the fourth insulating layer (460) to expose the fourth insulating layer on the first and second lower conductive layer patterns;
(h') forming a fifth insulating layer (480) on the planarization layer;
(i') forming a via hole to expose the second lower conductive layer pattern (450b,450c) by etching the fifth and fourth insulating layers; and
(j') forming an upper conductive layer pattern (490a,490b) to make contact with the second lower conductive layer pattern (450b,450c) through the via hole.

11. The method of claim 10, wherein the first and second lower conductive layer patterns are substantially thinner than 2×Y7/3.

12. The method of claim 10 or 11, wherein the step (g') comprises the substeps of: forming an SOG layer on the fourth insulating layer (460); baking the SOG layer; and etching back the SOG layer to expose the fourth insulating layer (460) on the first and second lower conductive layer patterns.

13. The method of any of claims 1 to 12, wherein the conductive layer pattern (130,230,330,430) has thickness of 5,000-10,000 Å.

14. The method of any of claims 1 to 13, wherein the baking substep is performed at a temperature of 150-400° C.

15. The method of any of claims 1 to 14, wherein the SOG contains an organic group.
